# EUROPEAN PATENT APPLICATION

(11) **EP 2 172 755 A1**
(43) Date of publication of application: **07.04.2010**
(21) Application number: 08017466.7
(22) Date of filing: 06.10.2008
(51) Int. Cl.: G01J 5/02, G01J 5/04, G01J 5/12, B81B 7/00

(54) **Infrared sensor with front side bandpass filter and vacuum cavity**

(71) Applicant: Sensirion AG, 8712 Stäfa (CH)
(72) Inventor: Streiff, Matthias, 8006 Zürich (CH); Sunier, Robert, 8046 Zürich (CH); Mayer, Felix, 8712 Stäfa (CH)
(74) Representative: Sutter, Kurt

(57) **Abstract**

An infrared sensor comprises a vacuum cavity (28) with a temperature sensor (4) located therein. An infrared filter plate (19) is located at a distance from and above the temperature sensor (4) by means of a spacer (20). The filter plate forms the top wall of the vacuum cavity (28). An additional seal layer (29) can be provided for sealing spacer (20) if spacer (20) not gas-tight. This design dispenses with a separate cap between the vacuum cavity (28) and the filter plate (19), which allows to manufacture the device more easily.

## Description

The invention relates to an infrared sensor with a temperature sensor arranged on a membrane in a vacuum cavity and with an infrared bandpass filter, as well as to a manufacturing method of such a sensor.

Infrared sensors for measuring radiation in the spectral range between 800 nm and 20 µm have a variety of applications, such as for contact-less temperature measurement as well as infrared spectroscopy.

A sensor of this type is described in DE 10 2004 002 163. It comprises a temperature sensor arranged on a membrane in a vacuum cavity. The lid of the vacuum cavity is formed by a cap of silicon, which is transparent in the infrared spectral range. A bandpass filter is mounted to the top of this cap. Infrared light passing through the bandpass filter and the cap reaches the temperature sensor and heats it up, which allows to measure the amount of light. Placing the temperature sensor in the vacuum cavity provides good thermal insulation, which increases the sensitivity of the device.

The problem to be solved by the present invention is to provide a sensor of this type that is easier to manufacture as well as a corresponding manufacturing method.

This problem is solved by the sensor and the method according to the independent claims.

Accordingly, the filter plate forms the top wall of the vacuum cavity. Hence, this design dispenses with a separate cap between the cavity and the filter plate, which allows to manufacture the device more easily.

A spacer can be provided between the top side of the substrate and the filter plate in order to keep the filter plate at the desired distance from the temperature sensor. Advantageously, the spacer is made of a material different from the filter plate, such as it can be optimized for its function.

In particular, the spacer can be made from solder or glass frit, which allows to form a gas-tight seal between the substrate and the filter plate.

Alternatively, the spacer may form a non-gas-tight connection, which is easier to manufacture. In that case, a further gas-tight seal layer covering at least part of the exterior of the filter plate, spacer and substrate can be provided for sealing the vacuum cavity.

Other advantageous embodiments are described in the dependent claims as well as in the following description. The description refers to the enclosed figures, wherein:
Fig. 1 is a top view of a first embodiment of a core sensor,
Fig. 2 is a sectional view along line II-II of Fig. 1,
Fig. 3 is a sectional view along line III-III of Fig. 1,
Fig. 4 is a sectional view of a second embodiment of a core sensor, corresponding to the view of Fig. 3,
Fig. 5 is a first embodiment of an infrared sensor based on the first core sensor,
Fig. 6 is a second embodiment of an infrared sensor based on the second core sensor,
Fig. 7 is a third embodiment of an infrared sensor based on the second core sensor,
Fig. 8 is a first step of a process for manufacturing the sensor of Fig. 6,
Fig. 9 is a second step of same process,
Fig. 10 is a first step of a process for manufacturing the sensor of Fig. 7,
Fig. 11 is a second step of the same process, and
Fig. 12 is a third step of the same process.

### Definitions:

Terms of the type "up", "top", "above" and "over", as well as "down", "bottom", "beneath" and "below" refer an orientation of sensor where the membrane is on the top side thereof. In other words, the membrane defines the top side of the substrate and the direction between the membrane side of the substrate and the opposite side of the substrate is the top down direction.

An "infrared bandpass filter" is a filter that allows transmission of part of the infrared spectrum. Such filters can be broad or narrow and they e.g. include interference filters.

The statement "a temperature sensor is arranged on the membrane" is to be understood such that the temperature sensor can be arranged on top of, within or below the membrane and is mechanically connected to and held by the membrane.

### The core sensor:

The present sensor is based on a "core sensor" comprising a substrate, a membrane mounted to the top side of the substrate, and a temperature sensor arranged on the membrane. This type of device is known to the skilled person. Its purpose is to suspend the temperature sensor in such a manner that it is thermally well insulated and allows to detect a temperature change even for low intensity infrared light.

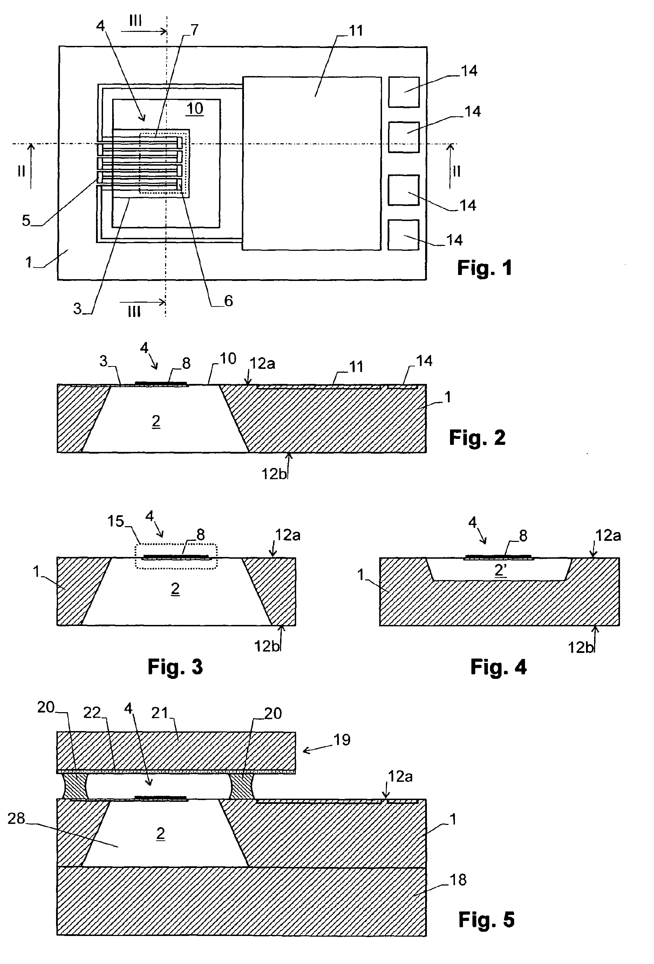

A first embodiment of such a core sensor is shown in Figs. 1 - 3. It comprises a substrate 1. Substrate 1 has an opening 2 formed therein, which has e.g. been manufactured by anisotropic etching. A membrane 3 is arranged over opening 2. Membrane 3 has e.g. been formed by applying one or more dielectric layers to the top of substrate 2 prior to etching opening 2.

A temperature sensor 4 is arranged on membrane 3. In the embodiment shown here, temperature sensor 4 is formed by a thermopile comprising a plurality of thermoelements having a first and a second series of junctions 5, 6 connected by leads 7 of two different types of materials, such as polysilicon and metal. The first series 5 of junctions is arranged over the bulk of substrate 1, while the second series 6 of junctions, which corresponds to temperature sensor 4, is located on membrane 3 above opening 2. Thus, the thermopile basically generates a voltage dependent on the temperature difference between the locations of the second series 6 of junctions on membrane 3 and the first series 5 of junctions on substrate 1. This type of arrangement is generally known to the skilled person. By way of example, we refer to EP 1 840 535, which shows a similar structure used for a flow sensor.

As the thermopile measures merely the temperature difference between its two contact rows 5, 6, it can be advantageous to provide, in addition thereto, an absolute temperature sensor, such as a band gap temperature sensor, on substrate 1.

Alternatively to using a thermopile, any other suitable type of temperature sensor, such as a resistive sensor, can be used as well.

An infrared absorber layer 8 is mounted to the top of membrane 3, covering at least the second series 6 of junctions. Its purpose is to increase the absorption of the incoming infrared light and to thereby increase the efficiency of the device. Absorber layer 8 can e.g. be a metal layer, such as aluminum.

As can be seen from Fig. 1, membrane 3 advantageously does not cover all of opening 2, but extends in tongue-like fashion from one side thereof. Hence, a gap 10 is formed on three sides of membrane 3, further increasing its thermal insulation.

Advantageously, substrate 1 is a semiconductor substrate, in particular a silicon substrate. Thus, it can carry integrated circuitry 11, advantageously at its top side 12a, such as amplifiers, analog/digital converters and digital circuitry.

Furthermore, a plurality of bond pads 14 is arranged on top side 12a of substrate 1. They serve to connect circuitry 11 and/or temperature sensor 4 to external devices.

Optionally, temperature sensor 4 can be insulated against heat transfer by means of an insulating coating, in particular an insulation layer of a nanoporous material, as indicated in dotted lines by reference numeral 15 in Fig. 3. This type of material, which consists of a solid having a large volume fraction of pores of sub-micrometer size, is known to reduce thermal conductance by limiting the path length of gas molecules. A description of such materials as well as of the related manufacturing methods can e.g. be found in EP 1 772 717. Such an insulation can be added to any of the infrared sensors described below - it is useful even if temperature sensor 4 is placed in a vacuum cavity because it still is able to reduce thermal conductance effects due to residual gas molecules.

Insulating material 15 should be transparent for the infrared light to be measured.

A second embodiment of a core sensor is shown in Fig. 4. It differs from the one of Figs. 1 - 3 only by the fact that a recess 2' is provided in the top side 12a of substrate 1 instead of opening 2. Recess 2' can e.g. also be formed by anisotropic etching, but the etching process takes place from the top side 12a and is stopped when recess 2' has reached the desired depth.

The core sensor of Figs. 1 - 4 can mostly be manufactured e.g. using standard CMOS-processes. Only the formation of opening 2 or recess 2' is carried out separately, e.g. using a special etching step as described above.

### The infrared sensor:

Even though the core sensor as described above is basically able to operate as an infrared sensor, the properties of the device can be refined by two measures:
a) Placing the temperature sensor in a vacuum chamber or on a wall of a vacuum chamber, i.e. a chamber with very low gas pressure. This allows to reduce convection related thermal conductance.
b) Providing an infrared bandpass filter such that only radiation within a spectral region of interest reaches temperature sensor 4.

Embodiments of infrared sensors using these measures are described in the following.

### Embodiment 1

The first embodiment, as shown in Fig. 5, is based on the core sensor described in reference to Figs. 1 - 3. As can be seen, the bottom end of opening 2 is closed by a cover 18, which is hermetically attached to the bottom side 12b of substrate 1. Cover 18 may e.g. be manufactured from a cover wafer that has been mounted to the bottom side of the base wafer later forming the substrates 1 and that has been cut into individual covers while dicing the base wafer.

A filter plate 19 comprising an infrared bandpass filter is mounted to the top side 12a of substrate 1 and separated from the same by means of a spacer 20. Spacer 20 is located between filter plate 19 and substrate 1 and extends all around temperature sensor 4.

Advantageously, spacer 20 is of a material different from filter plate 19 such that it can be optimized for its function.

In particular, spacer 20 can be formed by a material that provides a gas-tight seal as well as an adhesive bond with both substrate 1 and filter plate 19. Suitable materials for such a spacer are e.g. solder and glass frit.

Filter plate 19 of the embodiment of Fig. 5 is formed by a carrier layer 21 and a filter layer 22.

Carrier layer 21 is made of an IR-transparent material, such as silicon, and provides mechanical stability to filter plate 19.

Filter layer 22 is e.g. a single- or multilayer structure comprising several infrared-transparent layers of differing refractive index, such as layers of Ge, Si, and MgF₂, and forms the filter having the filtering properties as desired. This type of filters is known to the skilled person.

Filter plate 19 is mounted to spacer 20 with filter layer 22 facing temperature sensor 4. Thus, filter layer 22 is protected from mechanical wear and/or pollution.

Filter plate 19 has a substantially flat bottom side so it can be manufactured easily. The gap between temperature sensor 4 and filter plate 19, which is important for a good thermal insulation, corresponds to the height of spacer 20.

The design of the sensor of Fig. 5 allows to create a vacuum cavity 28, whose top wall is formed by filter plate 19, whose side walls are formed by spacer 20 as well as by the side walls of opening 2, and whose bottom all is formed by cover 18.

Vacuum cavity 28 is e.g. evacuated prior to connecting filter plate 19 to spacer 20. For example, filter plate 19 can be loosely deposited on spacer 20 and the assembly can be placed in an oven, which is subsequently evacuated in order to remove the gas from chamber 28. While maintaining the vacuum within the oven, the oven is heated up in order to melt spacer 20 at least partially, whereupon spacer 20 connects itself to filter plate 19 and forms a gas tight seal upon cooling.

Further details of possible manufacturing processes follow below.

### Embodiment 2

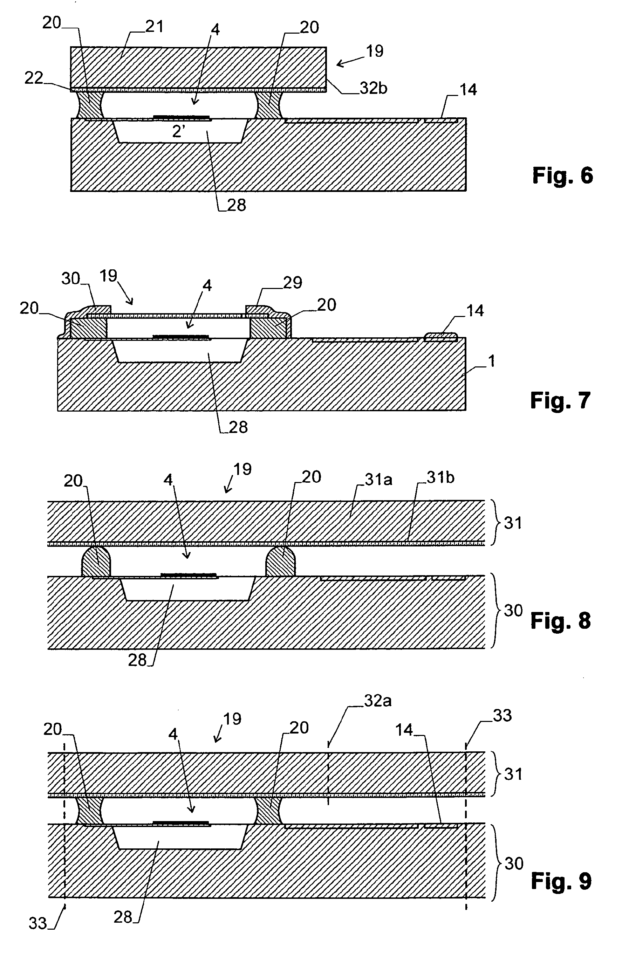

A second embodiment of an infrared sensor based on the second embodiment of the core sensor according to Fig. 4 is shown in Fig. 6. As can be seen, when using a core sensor with a recess 2' instead of an opening 2 in substrate 1, cover 18 can be dispensed with since the bottom of recess 28 forms the bottom of cavity 28.

### Embodiment 3

A third embodiment of the infrared sensor is shown in Fig. 7. It is basically the same as the embodiment of Fig. 6, but uses a non-gas-tight spacer 20. In addition, carrier layer 21 has been etched off from filter layer 22, and a gas-tight seal layer 29 has been applied.

The purpose of seal layer 29 is to seal vacuum cavity 28. It therefore covers all non-gastight parts and their neighborhood of the exterior side of filter plate 19, spacer 20 and substrate 1.

In the embodiment of Fig. 7, spacer 20 can e.g. be formed from a polymer.

### Manufacturing the sensor:

Even though some possible manufacturing steps have already been described above, the following provides a more specific description of advantageous manufacturing processes.

The described processes start by providing the core sensor, e.g. the sensor shown in Figs. 1 - 3 or Fig. 4 above. This core sensor can e.g. be formed, as described, by means of a standard CMOS process with subsequent etching in order to form opening 2 or recess 2'.

Typically, an assembly consisting of a plurality of the core sensors is provided on a wafer. This wafer will be called the "base wafer" in the following.

If the core sensor is of the type of Figs. 1 - 3, with an opening 2 reaching all the way through substrate 1, the bottom end of opening 2 must be closed by cover 18, as shown in Fig. 5. Advantageously, as mentioned, this is carried out by attaching a second wafer, the "cover wafer", to the bottom side of the base wafer, such that all openings 2 in the base wafer can be closed in a single step.

If the core sensor is of the type of Fig. 4, no cover 18 is required.

The following processes are described with reference to a core sensor of the type of Fig. 4, but they can also be carried out with a core sensor of the type of Figs. 1 - 3 when a cover wafer is applied to the bottom side of the base wafer as described above.

### Manufacturing process 1

The first manufacturing process can be used for manufacturing sensors of the types shown in Figs. 5 and 6.

As shown in Fig. 8, in a first step, a plurality of spacers 20 are mounted to the base wafer 30. Each spacer 20 surrounds one temperature sensor.

For this purpose, a meltable or bondable material, such as solder, (thermocompressive) gold or glass frit, is arranged at the location of the later spacers 20.

Alternatively, the spacers 20 may be mounted to the bottom side of filter wafer 31, or there may be spacers mounted to both wafers 30, 31.

Then, the filter plate 19 is placed on top of the meltable or bondable material. In an advantageous embodiment, filter plate 19 as applied as a single wafer 31 (subsequently called the "filter wafer") to all core sensors on base wafer 30 in a single step. Filter wafer 31 is in contact with the meltable or bondable material for the spacers 20 and covers all temperature sensors 4.

Filter wafer 31 consists e.g. of a silicon substrate 31a that will form carrier layer 21 of the individual filter plates 19, as well as of a coating structure 31b that will form the filter layer 22 of filter plate 19.

In a next step, base wafer 30 with the meltable or bondable material and filter wafer 31 are placed in an oven and the oven is evacuated, thereby evacuating later vacuum chamber 28 because the bond between the meltable or bondable material and filter wafer 31 is not yet gas-tight.

The meltable material is softened by heating, such that a bond is formed between filter plate 19 and the meltable material. Finally, the meltable material is hardened again by cooling in order to form the finished, gas-tight spacers 20. Thus, vacuum chamber 28 is formed in a single step.

The resulting assembly is shown in Fig. 9.

Now, parts of filter wafer 31 need to be removed, namely those parts that are above the contact pads 14. For this purpose, a wafer saw can be used to cut filter wafer 31 along lines 32a (see Fig. 9) without cutting into base wafer 30, thereby forming the future edge 32b (see Fig. 6) of filter plate 19. Then, further cuts through filter wafer 31 and base wafer 30 can be carried out along lines 33 (Fig. 9) in order to dice the sensor assembly into its various sensors

### Manufacturing process 2

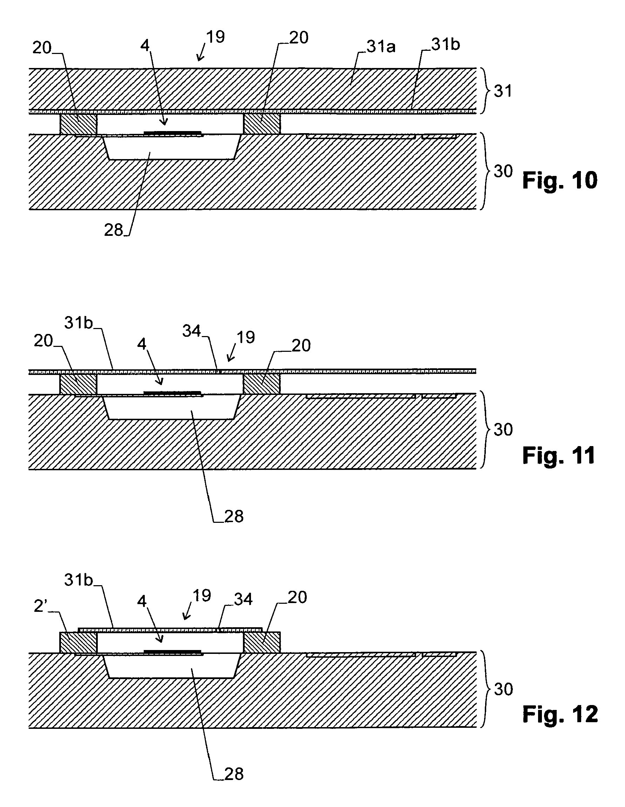

In order to manufacture a sensor of the type of Fig. 7, where no gas-tight connection is created by spacer 20, spacer 20 can e.g. be made of a polymer, such as a SU-8 or BCB. As shown in Fig. 10, it is formed at the top side of base wafer 30.

Then, filter plate 19 is applied, advantageously again in the form of a filter wafer 31. It can be glued to the top of the spacers 20.

The advantage of this procedure lies in the lower processing temperatures that are required as compared to the manufacturing process 1.

Now, silicon substrate 31a is removed by etching, as shown in Fig. 11, thus that only coating layer 31b remains.

Then, parts of the remaining filter plate, i.e. parts of layer structure 31b, are removed, namely those parts that do not cover the later vacuum chambers 28. Laser pulses are subsequently used to form at least one opening 34 extending through the remaining filter plate of each sensor.

The resulting structure, as shown in Fig. 12, is then placed in a vacuum chamber, where vacuum cavity 28 is evacuated through opening 34.

With the structure remaining under vacuum conditions in the vacuum chamber, seal layer 29 is applied, e.g. by means of sputtering. Seal layer 29 is advantageously of a metal, such aluminum. Seal layer 29 closes opening 34 and seals the spacers 20, thereby sealing vacuum chamber 28.

Now, the sensor assembly can be removed from the vacuum chamber and those parts of the seal layer that are not required can be removed by means of etching. If seal layer 29 is of a metal, such an etching process can be carried selectively and without affecting the dielectric top layers of the device. In the embodiment of Fig. 7, seal layer 29 is left over the spacers 20 and the adjacent areas of substrate 1 and filter plate 19, as well as over the contact pads 14, while it is removed everywhere else.

Finally, the sensor assembly can be diced in order to form the individual sensors as shown in Fig. 7.

### Notes

The sensors can be packaged, e.g. by using conventional techniques, such as those described in DE 10 2004 002 163.

The techniques described here can also be applied to infrared sensors that comprise an array of several temperature sensors arranged along a line or along a two-dimensional grid, which e.g. allows the recording of one- or two-dimensional infrared images. The temperature sensors can in this case either be placed in a common vacuum chamber or each one can be provided with an individual vacuum chamber.

To improve the efficiency of the present device, the filter of the present sensor can be provided with an anti-reflection coating on one or both sides. In particular, if a topmost or bottommost layer of the filter is formed by a highly refractive material, such as silicon, it can be covered by a coating having a lower refractive index. Anti-reflection coatings are known to the skilled person.

A getter for adsorbing gas molecules can be placed in vacuum cavity 28 for improving its vacuum maintaining capabilities. Such getters, which typically consist of a metal layer applied to an inner surface of the cavity under vacuum conditions, are also known to the skilled person.

## Claims

1. An infrared sensor comprising
a substrate (1),
a membrane (3) mounted on a top side of said substrate (1),
a temperature sensor (4) arranged on said membrane (3),
a filter plate (19) comprising an infrared bandpass filter, in particular an interference filter, and being arranged at a distance from and above said membrane (3) and said temperature sensor (4), and
a vacuum cavity (28), wherein said membrane (3) is mounted inside or at a wall of said vacuum cavity (28),
**characterized in that** said filter plate (19) forms a top wall of said vacuum cavity (28).

2. The sensor of any of the preceding claims further comprising a spacer (20) between said filter plate (19) and a top side of said substrate (1), wherein said spacer (20) is of a material different from said filter plate (19), and in particular wherein said filter plate (19) has a substantially flat bottom side.

3. The sensor of claim 2 wherein said spacer (20) is of solder or glass frit.

4. The sensor of claim 2 wherein said spacer (20) is non-gas-tight and wherein said sensor further comprises a gas-tight seal layer (29) covering at least part of an exterior side of said filter plate (19), said spacer (20) and said substrate (1) for sealing said vacuum cavity (28), and in particular wherein said seal layer (29) is of a metal.

5. The sensor of any of the preceding claims wherein said substrate (1) is a semiconductor substrate, in particular a silicon substrate and/or wherein said membrane (3) is arranged over a recess (2') in said substrate (1).

6. The sensor of any of the preceding claims wherein said membrane (3) is arranged over an opening (2) extending through said substrate (1) and wherein a cover (18) is arranged over a bottom end of said opening (2), wherein said cover (18) forms a bottom wall of said vacuum cavity (28), and in particular wherein said cover (18) is hermetically attached to a bottom side (12b) of said substrate (1).

7. The sensor of any of the preceding claims further comprising a nanoporous insulation layer (15) located at said temperature sensor (4).

8. A method for manufacturing an infrared sensor, in particular for manufacturing the sensor of any of the preceding claims, comprising the steps of
providing a core sensor having a substrate (1) with a membrane (3) mounted to a top side of said substrate (1) and a temperature sensor (4) arranged on said membrane (3),
mounting a filter plate (19) comprising an infrared bandpass filter, in particular an interference filter, at a distance above said membrane (3) and said temperature sensor (4),
**characterized by** the step of
creating a vacuum in order to form a vacuum cavity (28) in a space between said filter plate (19) and said substrate (1), with said filter plate (19) forming a top wall of said vacuum cavity (28).

9. The method of claim 8 further comprising the steps of arranging a spacer (20) between said substrate (1) and said filter plate (19), wherein said spacer (20) forms at least part of side walls of said vacuum cavity (28), in particular by carrying out the steps of
placing a meltable or bondable material on said substrate (1) and/or said filter plate (19),
placing said filter plate (19) on said meltable material,
and in particular by further carrying out the steps of
softening said meltable or bondable material by heating, thereby forming a bond between said meltable or bondable material and said filter plate (19), and
hardening said hardening material into said spacer (20).

10. The method of claim 9 wherein said meltable or bondable material is glass frit, gold or solder.

11. The method of any of the claims 9 or 10 comprising the step of forming a gas-tight seal layer (29) covering at least part of an exterior side of said filter plate (19), said spacer (20) and said substrate (1) for sealing said vacuum cavity (28).

12. The method of claim 11 further comprising the steps of
placing said substrate (1) with said filter plate (19) attached thereto into a vacuum, thereby evacuating said vacuum cavity (28) through an opening (34),
depositing said seal layer (29), thereby closing said opening (34) and sealing said vacuum cavity (28).

13. The method of claim 12 wherein said opening (34) extends through said filter plate (19).

14. The method of any of the claims 12 or 13 further comprising the steps of
attaching said filter plate (19) to said substrate (1) using a non-gas-tight spacer (20), then
placing said substrate (1) with said filter plate (19) and said spacer (20) in said vacuum and sealing said spacer (20) by applying said seal layer (29).

15. The method of any of the claims 8 to 14 comprising the steps of
providing a plurality of core sensors on a base wafer (30),
mounting a plurality of spacers (20) to said base wafer (30),
mounting a filter wafer (31) to said spacers (20), said filter wafer (31) covering said plurality of temperature sensors (4), thereby forming a sensor assembly, and
separating said sensor assembly into a plurality of said infrared sensors.

16. The method of claim 15 further comprising the step of removing parts of said filter wafer (31) after mounting said filter wafer (31) to said spacers (20) and prior to separating said sensor assembly.

17. The method of the claims 14 and 16 wherein said seal layer (29) is applied after removing said parts of said filter wafer (31),
and in particular wherein said filter wafer (31) comprises a carrier layer (21) and a filter layer (22) and is mounted to said spacers (20) with said filter layer (21) facing said temperature sensor (4), whereafter said carrier layer (22) is etched off, whereafter said filter layer (21) is structured by removing parts thereof, whereafter said seal layer (29) is applied.
